# FASCICULE DE BREVET EUROPEEN

(11) **EP 4 012 676 B1**
(45) Date de publication et mention de la délivrance du brevet: **06.05.2026**
(21) Numéro de dépôt: 21208587.2
(22) Date de dépôt: 16.11.2021
(51) Int. Cl.: G08B 13/14, G08B 29/12, G01R 31/08, G01R 31/58

(54) **DISPOSITIF ANTIVOL DE CÂBLE ÉLECTRIQUE ET PROCÉDÉ DE FONCTIONNEMENT ASSOCIÉ**
DIEBSTAHLSICHERUNGSVORRICHTUNG FÜR ELEKTRISCHE KABEL UND ENTSPRECHENDES FUNKTIONSVERFAHREN
ANTI-THEFT DEVICE FOR ELECTRIC CABLE AND ASSOCIATED OPERATING METHOD

(30) Priorité: 08.12.2020 FR 2012826
(43) Date de publication de la demande: 15.06.2022
(73) Titulaire: Nexans, 92400 Courbevoie (FR)
(72) Inventeur: POULIN, Nicolas, 62138 Auchy-les-Mines (FR)
(74) Mandataire: Cabinet Boettcher

(56) Documents cités:
- EP-A2- 3 567 562
- ES-U- 1 198 360
- US-A1- 2011 150 188
- US-A1- 2019 049 506

## Description

La présente invention se rapporte à un dispositif antivol de câble électrique ainsi qu'à un procédé de fonctionnement associé.

L'invention appartient au domaine des câbles électriques et des dispositifs de protection contre le vol ou autre cas de rupture non prévue de tels câbles.

Il arrive en effet qu'avant leur mise sous tension, des câbles ou des segments de câbles fassent l'objet d'un vol ou autre malveillance causant leur rupture, par exemple lorsqu'ils sont entreposés dans des tranchées, à même le sol ou à faible hauteur, dans l'attente d'être installés.

Ces ruptures malveillantes des câbles peuvent également intervenir après installation des câbles mais avant mise sous tension, en particulier si les câbles ne sont pas enterrés et se trouvent à des hauteurs aisément accessibles.

Afin de permettre une intervention suffisamment tôt pour que les câbles ne soient pas dérobés, il existe des dispositifs antivol de câbles.

On connaît par exemple par le document ES-U-1 198 360 un dispositif de détection de vol de câble d'éclairage. Une rupture dans le câblage du réseau électrique qui alimente l'installation d'éclairage comportant ce câble d'éclairage, due à une tentative de vol de ce câble d'éclairage, est détectée, soit pendant la journée, en l'absence d'éclairage, via la détection de la résistance électrique de la ligne de câble concernée, soit pendant la nuit, via la détection de l'intensité électrique du courant qui parcourt le câble. Un message d'alerte est alors envoyé sous forme de SMS à un terminal mobile donné.

Un tel dispositif présente diverses limites. Tout d'abord, il est nécessaire que le câble surveillé soit sous tension pour que ce dispositif antivol, fondé sur la détection d'une résistance électrique ou d'une intensité électrique, fonctionne. Par ailleurs, son principe de fonctionnement est lié à la nature des câbles surveillés, qui sont des câbles d'éclairage. Il ne s'applique donc pas à tout type de câble.

Le document US 2019/0049506 A1 divulgue un système de surveillance de l'intégrité de conducteurs de mise à la terre.

Le document EP 3 567 562 A2 divulgue un procédé de détection de vol de composant dans un système de génération de puissance électrique.

Le document US 2011/0150188 A1 divulgue un dispositif de test de systèmes d'alarme qui avertissent d'un danger tel qu'un incendie.

La présente invention a pour but de remédier aux inconvénients précités de l'art antérieur.

Dans ce but, la présente invention propose un dispositif de détection de rupture d'au moins un câble électrique, conforme à la revendication 1.

Ainsi, la rupture du câble provoque la perte du potentiel prédéterminé qui lui était appliqué et l'apparition d'un potentiel flottant, détecté immédiatement et de façon simple par l'unité de traitement. Cela permet de limiter les réparations et les retards à l'installation au cas où le câble sectionné n'était pas encore installé, voire les arrêts de production pour les utilisateurs, si le câble était déjà en cours d'exploitation.

Dans un mode particulier de réalisation, le dispositif comporte en outre une unité d'émission de signaux radiofréquence adaptée à émettre des signaux qui diffèrent selon que le potentiel détecté est le potentiel prédéterminé ou le potentiel flottant.

Cela permet au dispositif d'émettre un signal alertant de la détection effectuée. Ainsi, à réception de l'alerte, toute mesure d'intervention appropriée peut être prise par les personnels responsables du câble électrique en question.

Dans ce mode de réalisation, le dispositif peut comporter en outre un module de communication connecté à l'unité de traitement et à l'unité d'émission de signaux radiofréquence.

Un tel module de communication est optionnel. Il peut être prévu en variante à un mode d'échange direct de données entre l'unité de traitement et l'unité d'émission de signaux radiofréquence.

Dans un mode particulier de réalisation où le dispositif comporte l'unité d'émission de signaux radiofréquence précitée, cette unité d'émission peut faire partie intégrante de l'unité de traitement. Cela rend le dispositif plus compact, avec moins de composants.

Dans un mode particulier de réalisation où le dispositif comporte l'unité d'émission de signaux radiofréquence précitée, cette unité d'émission de signaux radiofréquence peut comporter au moins une antenne. Cela permet l'émission des signaux par voie aérienne vers un réseau de communication filaire ou sans fil, par exemple pour la transmission de l'alerte à la suite de la détection de rupture du câble électrique.

Dans un mode particulier de réalisation, le dispositif comporte en outre une unité de stockage d'énergie fournissant de l'énergie à l'unité d'alimentation en énergie.

Cela permet au dispositif d'être autonome en énergie et de pouvoir fonctionner même en l'absence d'alimentation secteur dans la zone où se situe le câble électrique.

Dans ce mode de réalisation, selon une caractéristique particulière éventuelle mais non nécessaire, le dispositif peut comporter en outre une unité d'adaptation de puissance connectée à l'unité de stockage d'énergie et à l'unité d'alimentation en énergie et fournissant à l'unité d'alimentation en énergie une puissance adaptée à partir de la puissance reçue en provenance de l'unité de stockage d'énergie.

Cet étage d'adaptation de puissance permet la compatibilité entre divers types d'unités de stockage d'énergie et divers types d'unités d'alimentation en énergie.

Dans un mode particulier de réalisation, l'unité de traitement comporte, parmi l'au moins une entrée, au moins une entrée spécifique adaptée à provoquer, en cas de changement d'état de l'entrée spécifique, une interruption du traitement en cours par l'unité de traitement et l'exécution d'un traitement prédéterminé par l'unité de traitement.

Cela permet à l'unité de traitement d'interrompre la tâche courante au profit, par exemple, d'une tâche de génération d'une alerte, en cas de passage du potentiel du câble électrique d'un potentiel prédéterminé à un potentiel flottant, si le câble subit une rupture.

L'unité de traitement est adaptée à adopter un état de veille profonde ou un état de réveil.

Ainsi, la consommation d'énergie étant très faible dans l'état de veille profonde, le dispositif conforme à l'invention est capable de fonctionner pendant plusieurs années en n'étant alimenté que par une simple pile ou autre élément de stockage limité d'énergie. En outre, l'état de réveil peut par exemple ne durer que le temps d'envoyer l'alerte susmentionnée et donc ne nécessiter également qu'une faible consommation d'énergie.

En effet, dans un mode particulier de réalisation, l'unité de traitement est adaptée, dans l'état de réveil, à engendrer l'émission, par l'unité d'émission de signaux radiofréquence, soit d'un signal d'alerte, en cas de détection du potentiel flottant, soit d'un signal de suivi, à intervalles de temps prédéterminés, en cas de détection du potentiel prédéterminé.

Cette disposition est avantageuse car elle permet aux personnes ad hoc, non seulement, par l'intermédiaire du signal d'alerte, d'être averties de la détection de la rupture du câble mais également, par l'intermédiaire du signal de suivi, de s'assurer que le dispositif est en bon état de fonctionnement.

Dans un mode particulier de réalisation, le dispositif comporte un premier et un second câbles électriques et une unité de traitement comportant une première et une seconde entrées respectivement connectées aux premier et second câbles électriques, l'unité de traitement étant adaptée à détecter, sur la première entrée, soit un premier potentiel prédéterminé, indicateur de l'intégrité du premier câble électrique, soit un potentiel flottant, indicateur de la rupture du premier câble électrique et, sur la seconde entrée, soit un second potentiel prédéterminé, indicateur de l'intégrité du second câble électrique, soit un potentiel flottant, indicateur de la rupture du second câble électrique.

Ainsi, dans ce mode de réalisation, le dispositif peut surveiller deux câbles à la fois, grâce aux deux entrées de l'unité de traitement dédiées à cet effet.

Dans le même but que celui indiqué plus haut, la présente invention propose également un procédé de détection de rupture d'au moins un câble électrique, conforme à la revendication 11.

Dans un mode particulier de réalisation, le procédé comporte en outre une étape consistant à envoyer, par une unité d'émission de signaux radiofréquence, un signal d'alerte en cas de détection du potentiel flottant précité.

Dans ce mode de réalisation, selon une caractéristique particulière possible mais non nécessaire, l'étape d'envoi du signal d'alerte peut comporter l'envoi d'un message à un terminal mobile de télécommunications, par l'intermédiaire d'un réseau de télécommunications.

Les caractéristiques particulières et les avantages du procédé étant similaires à ceux du dispositif, ils ne sont pas répétés ici.

### Brève description des dessins

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :
[Fig. 1] est une représentation schématique d'un dispositif de détection de rupture de câble électrique conforme à la présente invention, dans un mode particulier de réalisation où le dispositif comporte deux câbles électriques ;
[Fig. 2] est une représentation schématique simplifiée comparative d'un dispositif conforme à la présente invention dans un état où le câble est intègre et dans un état où le câble est sectionné, dans un mode particulier de réalisation où le dispositif comporte un seul câble électrique ;
[Fig. 3] est un organigramme illustrant des étapes d'un procédé de détection de rupture de câble électrique conforme à la présente invention, dans un mode particulier de réalisation ; et
[Fig. 4] est un organigramme illustrant le fonctionnement d'une unité de traitement comprise dans le dispositif conforme à la présente invention, dans un mode particulier de réalisation.

### Description de mode(s) de réalisation

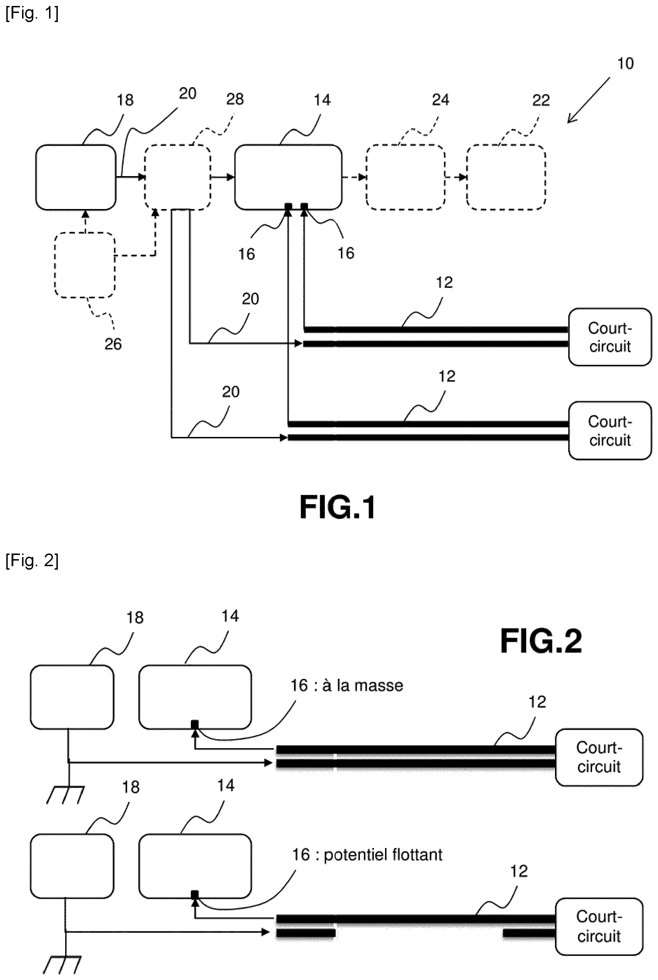

La figure 1 montre une vue schématique d'un dispositif 10 de détection de rupture de câble électrique conforme à la présente invention, dans un mode particulier de réalisation où le dispositif 10 comporte deux câbles électriques 12 à surveiller. Ce nombre particulier de câbles électriques 12 n'est qu'un exemple parmi d'autres, le nombre de câbles pouvant être quelconque.

Le câble électrique 12 considéré peut par exemple être un câble électrique de puissance, destiné par exemple au transport d'énergie et/ou à la transmission de données, comme par exemple un câble de signalisation.

A titre d'exemple non limitatif, il peut s'agir d'un câble de plusieurs kilomètres de longueur, destiné à être enterré dans une tranchée, entre deux stations ou sous-stations d'une infrastructure de fourniture d'énergie.

Outre ce ou ces câble(s) 12, le dispositif 10 comporte une ou plusieurs unité(s) 14 de traitement.

Chaque unité 14 de traitement comporte notamment une entrée 16 connectée au câble électrique 12.

Dans le mode particulier de réalisation de la figure 1, le dispositif 10 comporte une unité 14 de traitement qui comporte deux entrées 16, respectivement connectées aux deux câbles électriques 12 à surveiller.

A titre d'exemple non limitatif, l'unité 14 de traitement peut être un microcontrôleur ou tout autre type de composant ou d'ensemble de composants traitant des données et disposant au moins, pour ce faire, d'un élément du type transistor, d'une mémoire et d'un système de gestion d'entrées/sorties.

Le dispositif 10 comporte par ailleurs une ou plusieurs unité(s) 18 d'alimentation en énergie alimentant la ou les unité(s) 14 de traitement.

Dans le mode particulier de réalisation de la figure 1, le dispositif 10 comporte une unité 18 d'alimentation en énergie alimentant l'unité 14 de traitement. En variante, plusieurs unités 18 d'alimentation en énergie peuvent alimenter une même unité 14 de traitement.

Conformément à la présente invention, l'unité 18 d'alimentation en énergie comporte un moyen 20 d'application d'un potentiel prédéterminé au câble électrique 12 et l'unité 14 de traitement est adaptée à détecter, sur au moins une de ses entrées 16, soit ce potentiel prédéterminé, soit un potentiel flottant.

En effet, comme le montre la figure 1, le dispositif 10 est connecté, via son unité 18 d'alimentation en énergie et son unité 14 de traitement, à deux conducteurs de chaque câble 12 et un court-circuit est établi à l'autre extrémité du câble 12.

Le potentiel prédéterminé, c'est-à-dire une valeur prédéterminée de potentiel détectée par le moyen 20 aux bornes du câble 12 surveillé, indique que le câble électrique 12 auquel cette entrée 16 de l'unité 14 de traitement est connectée est intègre, autrement dit non endommagé et notamment non sectionné pour être dérobé.

En revanche, le potentiel flottant, c'est-à-dire une valeur indéterminée de potentiel détectée par le moyen 20 aux bornes du câble 12 surveillé, indique que le câble électrique 12 auquel cette entrée 16 de l'unité 14 de traitement est connectée a subi une dégradation, par exemple une rupture.

Ainsi, dans le mode de réalisation de la figure 1, l'unité 14 de traitement comporte une première et une seconde entrées 16 chacune connectée à l'un des câbles électriques 12 et l'unité 14 de traitement étant adaptée à détecter, sur sa première entrée 16, soit un premier potentiel prédéterminé, indicateur de l'intégrité du câble électrique 12 auquel cette entrée 16 est connectée, soit un potentiel flottant, indicateur de la rupture de ce même câble électrique 12 et, sur sa seconde entrée 16, soit un second potentiel prédéterminé, indicateur de l'intégrité de l'autre câble électrique 12, soit un potentiel flottant, indicateur de la rupture de cet autre câble électrique 12.

Les premier et second potentiels prédéterminés ne sont pas nécessairement identiques, mais peuvent l'être.

A titre d'exemple nullement limitatif, de façon générale, le potentiel prédéterminé peut être nul, c'est-à-dire qu'un câble électrique 12 surveillé par le dispositif 10 peut être relié à la masse.

La figure 2 illustre un exemple de ce type, où le dispositif 10 comporte un seul câble électrique 12 qui se voit appliquer un potentiel nul lorsqu'il est intègre (schéma du haut sur le dessin) et présente un potentiel flottant en cas de rupture (schéma du bas sur le dessin).

Comme le montre la figure 1, le dispositif 10 peut comporter en outre un ou plusieurs des éléments optionnels 22, 24, 26 et 28, représentés en tirets sur le dessin et décrits ci-dessous. Il est à noter que dans le mode de réalisation de la figure 2, le dispositif 10 ne comporte aucun de ces éléments optionnels 22, 24, 26 et 28.

Ainsi, dans un mode particulier de réalisation, le dispositif 10 comporte en outre, de façon optionnelle, une unité 22 d'émission de signaux radiofréquence adaptée à émettre des signaux qui diffèrent selon que le potentiel détecté est le potentiel prédéterminé ou le potentiel flottant.

Dans ce mode particulier de réalisation, le dispositif 10 peut de plus comporter, de façon optionnelle, un module 24 de communication connecté à l'unité 14 de traitement et à l'unité 22 d'émission de signaux radiofréquence.

En variante, l'unité 22 d'émission de signaux radiofréquence peut être intégrée dans l'unité 14 de traitement.

Dans un mode particulier de réalisation où le dispositif 10 comporte une unité 22 d'émission de signaux radiofréquence, cette unité 22 d'émission de signaux radiofréquence peut comporter une ou plusieurs antenne(s), adaptée(s) à émettre ces signaux radiofréquence par voie aérienne vers l'extérieur du dispositif 10.

Comme l'illustre la figure 1, à titre optionnel, le dispositif 10 peut également comporter une unité 26 de stockage d'énergie. Il peut s'agir par exemple d'une batterie ou pile tout autre moyen d'accumulation d'énergie, y compris de type photovoltaïque.

L'unité 26 de stockage d'énergie fournit de l'énergie à l'unité 18 d'alimentation en énergie, ce qui permet au dispositif 10 de fonctionner en l'absence de tout raccordement au secteur et de toute autre source d'énergie à proximité de l'emplacement du dispositif 10 et en particulier à proximité de l'emplacement du ou des câble(s) 12 à surveiller.

Comme mentionné plus haut, cela est utile lorsque par exemple, une longueur de plusieurs kilomètres de câble 12 est entreposée entre deux stations ou sous-stations d'une infrastructure de fourniture d'énergie électrique, avant d'être installée et reliée à ces deux stations ou sous-stations.

Dans un mode particulier de réalisation où le dispositif 10 comporte une telle unité 26 de stockage d'énergie, toujours de façon optionnelle, le dispositif 10 peut comporter en outre une unité 28 d'adaptation de puissance.

Comme l'illustre la figure 1, l'unité 28 d'adaptation de puissance est connectée à l'unité 26 de stockage d'énergie et à l'unité 18 d'alimentation en énergie et fournit à l'unité 18 d'alimentation en énergie une puissance adaptée à partir de la puissance reçue en provenance de l'unité 26 de stockage d'énergie.

Dans ce mode de réalisation, le moyen 20 précité d'application d'un potentiel prédéterminé au câble électrique 12, compris dans l'unité 18 d'alimentation en énergie, fournit ce potentiel à l'unité 28 d'adaptation de puissance, qui l'applique au câble électrique 12 à surveiller. Lorsque le dispositif 10 ne comporte pas d'unité 28 d'adaptation de puissance, le moyen 20 applique le potentiel directement au câble électrique 12 à surveiller. Sur la figure 1, cela est matérialisé par des flèches entre l'unité 18 d'alimentation en énergie, l'unité 28 d'adaptation de puissance et les câbles électriques 12.

Dans un mode particulier de réalisation, l'unité 14 de traitement comporte, parmi ses entrées 16 si elle en comporte plusieurs, au moins une entrée spécifique. Lorsque l'état de cette entrée 16 spécifique change, cela provoque une interruption du traitement en cours au sein de l'unité 14 de traitement, qui exécute alors un traitement prédéterminé, qui peut par exemple avoir été préprogrammé.

L'unité 14 de traitement est adaptée à adopter un état de veille profonde ou un état de réveil. Le changement d'état précité peut ainsi consister en un passage de l'état de veille profonde à l'état de réveil et vice versa.

Le passage de l'état de veille profonde à l'état de réveil survient notamment lors de la détection du potentiel flottant par l'unité 14 de traitement, pour l'exécution d'un traitement donné, tel que la génération d'un signal d'alerte, indiquant la détection de ce potentiel flottant.

Le passage de l'état de veille profonde à l'état de réveil peut aussi survenir à des instants définis, par exemple préprogrammés, par exemple selon des intervalles de temps donnés, pour l'exécution d'un traitement donné, tel que la génération d'un signal de suivi, indiquant la détection du potentiel prédéterminé précité.

Dans un mode de réalisation où le dispositif 10 comporte une unité 22 d'émission de signaux radiofréquence, ce signal de suivi peut alors être émis par l'unité 22 d'émission sous forme d'un message de « bonne santé » du câble électrique 12 surveillé, à destination d'un élément choisi de réception, tel qu'un terminal de télécommunications fixe ou mobile, par l'intermédiaire d'un réseau de télécommunications filaire ou sans fil.

A titre d'exemple nullement limitatif, le réseau peut être un réseau de type GSM (acronyme anglais signifiant « Global System for Mobile Communications », système mondial de communication avec les mobiles) ou tout autre type de réseau de communication.

A titre d'exemple non limitatif, on peut prévoir l'émission d'un tel signal de suivi à une certaine périodicité, par exemple une fois par jour.

Dans un mode de réalisation où l'unité 22 d'émission comporte une antenne, le signal de suivi est émis par l'antenne par voie aérienne.

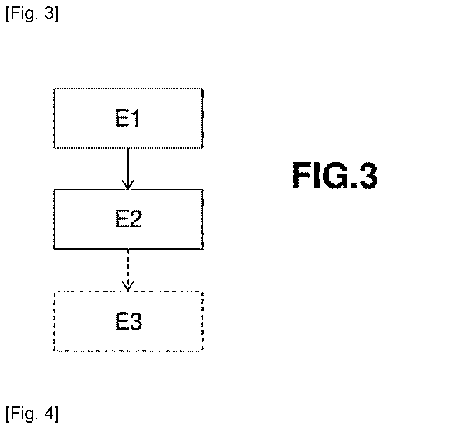

L'organigramme de la figure 3 illustre des étapes d'un procédé de détection de rupture d'au moins un câble électrique 12.

Conformément à la présente invention, ce procédé comporte une étape E1 consistant à appliquer le potentiel prédéterminé précité au câble électrique 12 et une étape subséquente E2 consistant à détecter, sur au moins une entrée 16 de l'unité 14 de traitement connectée au câble électrique 12, soit le potentiel prédéterminé, indicateur de l'intégrité de ce câble électrique 12, soit un potentiel flottant, indicateur de la rupture de ce même câble électrique 12.

De façon optionnelle, comme illustré en tirets sur la figure 2, le procédé peut comporter en outre une étape E3 postérieure à l'étape E2 consistant à envoyer un signal d'alerte en cas de détection du potentiel flottant précité, comme décrit plus haut en référence au dispositif 10.

Dans un mode particulier de réalisation, l'étape E3 d'envoi du signal d'alerte peut comporter l'envoi d'un message à un terminal mobile de télécommunications, par l'intermédiaire d'un réseau de télécommunications, comme décrit plus haut en référence au dispositif 10. A titre d'exemple non limitatif, le message peut être envoyé sous forme d'un texto. Cet envoi ne nécessite donc pas d'accès au réseau Internet dans le déroulement des étapes du procédé de détection conforme à l'invention. En revanche, de façon optionnelle, à partir d'un message d'alerte sous forme de texto, un site Internet lié au réseau de télécommunications précité peut, à partir de ce texto, envoyer un courriel à une adresse prédéfinie.

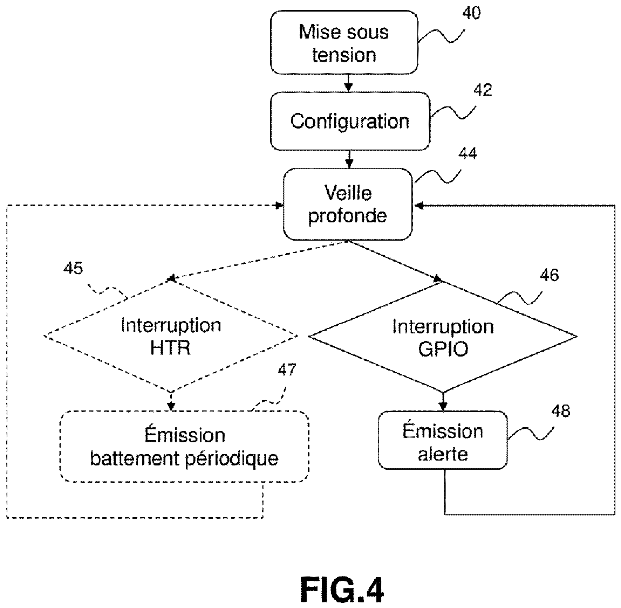

L'organigramme de la figure 4 illustre le fonctionnement de l'unité 14 de traitement comprise dans le dispositif 10 conforme à la présente invention, dans un mode particulier de réalisation.

Lors d'une étape initiale 40, l'unité 14 de traitement est mise sous tension grâce à l'unité 18 d'alimentation en énergie. Puis lors d'une étape 42, elle est configurée, notamment de façon à adopter par défaut un état 44 de veille profonde.

Lors de la détection du potentiel flottant en cas de sectionnement du câble 12 surveillé, comme décrit plus haut, l'unité 14 de traitement passe de l'état de veille profonde à l'état de réveil.

A l'étape suivante 46, ce changement d'état provoque la génération, par l'entrée 16 spécifique précitée de l'unité 14 de traitement ou une entrée 16 générique du type GPIO (en anglais « General Purpose Input-Output »), d'une interruption du traitement en cours, pour exécuter un autre traitement consistant en l'émission d'un signal d'alerte, à l'étape suivante 48.

Après émission de cette alerte, l'unité 14 de traitement retourne à l'état 44 de veille profonde.

La branche de l'organigramme représentée en tirets sur la figure 4 est optionnelle. Dans un mode particulier de réalisation, elle consiste, pour l'entrée 16 de l'unité 14 de traitement, à provoquer, lors d'une étape optionnelle 45, une interruption du traitement en cours, à des instants prédéfinis de passage de l'état de veille profonde à l'état de réveil, sur commande d'une horloge qui peut être comprise dans l'unité 14 de traitement.

L'horloge est par exemple du type horloge temps réel (HTR, en anglais RTC pour « Real-Time Clock »). L'unité 14 de traitement émet alors, à l'étape suivante optionnelle 47, un signal de suivi du bon état de fonctionnement du dispositif 10. Dans le mode particulier de réalisation de la figure 4, cette émission est faite à une fréquence choisie, sous forme d'un « battement de cœur » périodique, par exemple une émission par jour.

La présente invention permet de surveiller l'intégrité de câbles électriques à distance et de façon simple, efficace, peu coûteuse et économique en énergie et en moyens humains, sans qu'il soit nécessaire de modifier le processus de fabrication de ces câbles.

## Revendications

1. Dispositif (10) de détection de rupture d'au moins un câble électrique (12), ledit dispositif (10) comportant :
ledit au moins un câble électrique (12),
au moins une unité (14) de traitement comportant au moins une entrée (16) connectée audit au moins un câble électrique (12),
au moins une unité (18) d'alimentation en énergie alimentant ladite au moins une unité (14) de traitement,
ledit dispositif étant **caractérisé en ce que** :
ladite au moins une unité (18) d'alimentation en énergie comporte un moyen (20) d'application d'un potentiel prédéterminé audit au moins un câble électrique (12) ; et
ladite au moins une unité (14) de traitement est configurée pour adopter par défaut un état de veille profonde et est adaptée à détecter, sur au moins une de ladite au moins une entrée (16), soit ledit potentiel prédéterminé, indicateur de l'intégrité dudit au moins un câble électrique (12), soit un potentiel flottant, indicateur de ladite rupture dudit au moins un câble électrique (12), ledit potentiel flottant étant détecté par le passage à un état de réveil de ladite au moins une unité (14) de traitement.

2. Dispositif (10) selon la revendication 1, **caractérisé en ce qu'**il comporte en outre une unité (22) d'émission de signaux radiofréquence adaptée à émettre des signaux qui diffèrent selon que le potentiel détecté est ledit potentiel prédéterminé ou ledit potentiel flottant.

3. Dispositif (10) selon la revendication 2, **caractérisé en ce qu'**il comporte en outre un module (24) de communication connecté à ladite unité (14) de traitement et à ladite unité (22) d'émission de signaux radiofréquence.

4. Dispositif (10) selon la revendication 2, **caractérisé en ce que** ladite unité (14) de traitement comporte ladite unité (22) d'émission de signaux radiofréquence.

5. Dispositif (10) selon l'une quelconque des revendications 2 à 4, **caractérisé en ce que** ladite unité (22) d'émission de signaux radiofréquence comporte au moins une antenne.

6. Dispositif (10) selon l'une quelconque des revendications précédentes, **caractérisé en ce qu'**il comporte en outre une unité (26) de stockage d'énergie fournissant de l'énergie à ladite unité (18) d'alimentation en énergie.

7. Dispositif (10) selon la revendication précédente, **caractérisé en ce qu'**il comporte en outre une unité (28) d'adaptation de puissance connectée à ladite unité (26) de stockage d'énergie et à ladite unité (18) d'alimentation en énergie et fournissant à ladite unité (18) d'alimentation en énergie une puissance adaptée à partir de la puissance reçue en provenance de ladite unité (26) de stockage d'énergie.

8. Dispositif (10) selon l'une quelconque des revendications précédentes, **caractérisé en ce que** ladite unité (14) de traitement comporte, parmi ladite au moins une entrée (16), au moins une entrée spécifique adaptée à provoquer, en cas de changement d'état de ladite entrée spécifique, une interruption du traitement en cours par ladite unité (14) de traitement et l'exécution d'un traitement prédéterminé par ladite unité (14) de traitement.

9. Dispositif (10) selon la revendication précédente et l'une quelconque des revendications 2 à 5, **caractérisé en ce que** ladite unité (14) de traitement est adaptée, dans ledit état de réveil, à engendrer l'émission, par ladite unité (22) d'émission de signaux radiofréquence, soit d'un signal d'alerte, en cas de détection dudit potentiel flottant, soit d'un signal de suivi, à intervalles de temps prédéterminés, en cas de détection dudit potentiel prédéterminé.

10. Dispositif (10) selon l'une quelconque des revendications précédentes, **caractérisé en ce qu'**il comporte un premier et un second câbles électriques (12) et une unité (14) de traitement comportant une première et une seconde entrées (16) respectivement connectées auxdits premier et second câbles électriques (12), ladite unité (14) de traitement étant adaptée à détecter, sur ladite première entrée (16), soit un premier potentiel prédéterminé, indicateur de l'intégrité dudit premier câble électrique (12), soit un potentiel flottant, indicateur de la rupture dudit premier câble électrique (12) et, sur ladite seconde entrée (16), soit un second potentiel prédéterminé, indicateur de l'intégrité dudit second câble électrique (12), soit un potentiel flottant, indicateur de la rupture dudit second câble électrique (12).

11. Procédé de détection de rupture d'au moins un câble électrique (12), ledit procédé étant **caractérisé en ce qu'**il comporte des étapes consistant à :
appliquer (E1), par une unité (18) d'alimentation en énergie, un potentiel prédéterminé audit au moins un câble électrique (12) ;
détecter (E2), par une unité (14) de traitement alimentée par l'unité (18) d'alimentation en énergie et configurée pour adopter par défaut un état de veille profonde, sur au moins une entrée (16) de ladite unité (14) de traitement connectée audit au moins un câble électrique (12), soit ledit potentiel prédéterminé, indicateur de l'intégrité dudit au moins un câble électrique (12), soit un potentiel flottant, indicateur de ladite rupture dudit au moins un câble électrique (12), ledit potentiel flottant étant détecté par le passage à un état de réveil de ladite au moins une unité (14) de traitement.

12. Procédé selon la revendication précédente, **caractérisé en ce qu'**il comporte en outre une étape (E3) consistant à envoyer, par une unité (22) d'émission de signaux radiofréquence, un signal d'alerte en cas de détection dudit potentiel flottant.

13. Procédé selon la revendication précédente, **caractérisé en ce que** ladite étape (E3) d'envoi dudit signal d'alerte comporte l'envoi d'un message à un terminal mobile de télécommunications, par l'intermédiaire d'un réseau de télécommunications.

## Patentansprüche

1. Vorrichtung (10) zur Erkennung des Bruchs von mindestens einem elektrischen Kabel (12), wobei die genannte Vorrichtung (10) Folgendes aufweist:
mindestens eines der genannten elektrischen Kabel (12),
mindestens eine Verarbeitungseinheit (14), die mindestens einen Eingang (16) aufweist, der mit mindestens einem der genannten elektrischen Kabel (12) verbunden ist,
mindestens eine Einheit (18) zur Energieversorgung, die die genannte Verarbeitungseinheit (14) mit Energie versorgt,
wobei die genannte Vorrichtung **dadurch gekennzeichnet ist, dass**:
die genannte Einheit (18) zur Energieversorgung umfasst ein Mittel (20) zum Anlegen eines vordefinierten Potenzials an mindestens einem der genannten elektrischen Kabel (12); und
die genannte Verarbeitungseinheit (14) ist so konfiguriert, dass sie standardmäßig einen Tiefschlafzustand einnimmt und dazu ausgebildet ist, an mindestens einem der genannten Eingänge (16) entweder das genannte vordefinierte Potenzial als Indikator für die Integrität des genannten elektrischen Kabels (12) oder ein schwebendes Potenzial als Indikator für die Unterbrechung des genannten elektrischen Kabels (12) zu erkennen, wobei das genannte schwebende Potenzial durch den Übergang der genannten Verarbeitungseinheit (14) in einen Aufwachzustand erkannt wird.

2. Vorrichtung (10) nach Anspruch 1, **dadurch gekennzeichnet, dass** sie ferner eine Sendeeinheit (22) für Radiofrequenzsignale aufweist, die eingerichtet ist, Signale zu senden, die sich unterscheiden, je nachdem, ob das erkannte Potenzial das genannte vordefinierte Potenzial oder das genannte schwebende Potenzial ist.

3. Vorrichtung (10) nach Anspruch 2, **dadurch gekennzeichnet, dass** sie ferner ein Kommunikationsmodul (24) aufweist, das mit der genannten Verarbeitungseinheit (14) und der genannten Sendeeinheit (22) für Radiofrequenzsignale verbunden ist.

4. Vorrichtung (10) nach Anspruch 2, **dadurch gekennzeichnet, dass** die genannte Verarbeitungseinheit (14) die genannte Sendeeinheit (22) für Radiofrequenzsignale aufweist.

5. Vorrichtung (10) gemäß einem der Ansprüche 2 bis 4, **dadurch gekennzeichnet, dass** die genannte Sendeeinheit (22) für Radiofrequenzsignale mindestens eine Antenne aufweist.

6. Vorrichtung (10) gemäß einem der vorstehenden Ansprüche, **dadurch gekennzeichnet, dass** sie ferner eine Energiespeichereinheit (26) aufweist, die der genannten Einheit (18) zur Energieversorgung Energie zuführt.

7. Vorrichtung (10) nach dem vorhergehenden Anspruch, **dadurch gekennzeichnet, dass** sie ferner eine Leistungsanpassungseinheit (28) aufweist, die mit der genannten Energiespeichereinheit (26) und der genannten Einheit (18) zur Energieversorgung verbunden ist und der genannten Einheit (18) zur Energieversorgung aus der von der genannten Energiespeichereinheit (26) empfangenen Leistung eine angepasste Leistung liefert.

8. Vorrichtung (10) gemäß einem der vorstehenden Ansprüche, **dadurch gekennzeichnet, dass** die genannte Verarbeitungseinheit (14) unter den genannten Eingängen (16) mindestens einen spezifischen Eingang aufweist, der so ausgebildet ist, dass bei einer Zustandsänderung dieses spezifischen Eingangs die laufende Verarbeitung durch die genannte Verarbeitungseinheit (14) unterbrochen wird und die genannte Verarbeitungseinheit (14) eine vordefinierte Verarbeitung ausführt.

9. Vorrichtung (10) nach dem vorhergehenden Anspruch und einem der Ansprüche 2 bis 5, **dadurch gekennzeichnet, dass** die genannte Verarbeitungseinheit (14) im genannten Aufwachzustand dazu ausgebildet ist, die Aussendung durch die genannte Sendeeinheit (22) für Radiofrequenzsignale zu veranlassen, entweder eines Alarmsignals im Falle der Detektion des genannten schwebenden Potenzials, oder eines Überwachungssignals in vordefinierten Zeitintervallen im Falle der Detektion des genannten vordefinierten Potenzials.

10. Vorrichtung (10) gemäß einem der vorstehenden Ansprüche, **dadurch gekennzeichnet, dass** sie ein erstes und ein zweites elektrisches Kabel (12) und eine Verarbeitungseinheit (14) aufweist, die erste und zweite Eingänge (16) aufweist, die jeweils mit den genannten ersten bzw. zweiten elektrischen Kabeln (12) verbunden sind, wobei die genannte Verarbeitungseinheit (14) dazu ausgebildet ist, am genannten ersten Eingang (16) entweder ein erstes vordefiniertes Potenzial zu detektieren, das ein Indikator für die Integrität des genannten ersten elektrischen Kabels (12) ist, oder ein schwebendes Potenzial, das ein Indikator für den Bruch des genannten ersten elektrischen Kabels (12) ist, und am genannten zweiten Eingang (16) entweder ein zweites vordefiniertes Potenzial zu detektieren, das ein Indikator für die Integrität des genannten zweiten elektrischen Kabels (12) ist, oder ein schwebendes Potenzial, das ein Indikator für den Bruch des genannten zweiten elektrischen Kabels (12) ist.

11. Verfahren zur Erkennung des Bruchs von mindestens einem elektrischen Kabel (12), wobei das Verfahren **dadurch gekennzeichnet ist, dass** es Schritte umfasst, die bestehen aus :
anlegen (E1) durch eine Einheit (18) zur Energieversorgung eines vordefinierten Potenzials an mindestens einem der genannten elektrischen Kabel (12);
detektieren (E2) durch eine Verarbeitungseinheit (14), die von der Einheit (18) zur Energieversorgung gespeist wird und so konfiguriert ist, dass sie standardmäßig einen Tiefschlafzustand einnimmt, an mindestens einem Eingang (16) der genannten Verarbeitungseinheit (14), der mit mindestens einem der genannten elektrischen Kabel (12) verbunden ist, entweder das genannte vordefinierte Potenzial als Indikator für die Integrität des genannten elektrischen Kabels (12) oder ein schwebendes Potenzial als Indikator für den Bruch des genannten elektrischen Kabels (12) zu erkennen, wobei das genannte schwebende Potenzial durch den Übergang der genannten Verarbeitungseinheit (14) in einen Aufwachzustand erkannt wird.

12. Verfahren nach dem vorhergehenden Anspruch, **dadurch gekennzeichnet, dass** es ferner einen Schritt (E3) umfasst, bei dem von einer Sendeeinheit (22) für Radiofrequenzsignale ein Alarmsignal im Falle der Detektion des genannten schwebenden Potenzials gesendet wird.

13. Verfahren nach dem vorhergehenden Anspruch, **dadurch gekennzeichnet, dass** der genannte Schritt (E3) des Sendens des genannten Alarmsignals das Senden einer Nachricht an ein mobiles Telekommunikationsendgerät mittels eines Telekommunikationsnetzes umfasst.

## Claims

1. Device (10) for detecting a break in at least one electrical cable (12), said device (10) comprising:
said at least one electrical cable (12),
at least one processing unit (14) comprising at least one input (16) connected to said at least one electrical cable (12),
at least one power supply (18) powering said at least one processing unit (14),
said device being **characterised in that**:
said at least one power supply (18) comprises means (20) for applying a predetermined potential to said at least one electrical cable (12); and
said at least one processing unit (14) is configured, by default, to adopt a deep sleep state and is adapted to detect, on at least one of said inputs (16), either said predetermined potential, indicative of the integrity of said at least one electrical cable (12), or a floating potential, indicative of a break in said at least one electrical cable (12), said floating potential being detected by the transition of said at least one processing unit (14) to a wake state.

2. Device (10) according to claim 1, **characterised in that** it further comprises a radiofrequency signal transmission unit (22) adapted to emit signals that differ depending on whether the detected potential is said predetermined potential or said floating potential.

3. Device (10) according to claim 2, **characterised in that** it further comprises a communication module (24) connected to said processing unit (14) and to said radiofrequency signal transmission unit (22).

4. Device (10) according to claim 2, **characterised in that** said processing unit (14) comprises said radiofrequency signal transmission unit (22).

5. Device (10) according to any one of claims 2 to 4, **characterised in that** said unit (22) for transmitting radiofrequency signals comprises at least one antenna.

6. Device (10) according to any one of the preceding claims, **characterised in that** it further comprises a unit (26) for energy storage providing energy to said power supply unit (18).

7. Device (10) according to the previous claim, **characterised in that** it further comprises a power adaptation unit (28) connected to said energy storage unit (26) and to said power supply unit (18) and configured to supply said power supply unit (18) with an appropriate power level based on the power received from said energy storage unit (26).

8. Device (10) according to any one of the preceding claims, **characterised in that** said processing unit (14) comprises, among said at least one input (16), at least one specific input adapted to cause, upon a change of state of said specific input, the interruption of processing in progress by said processing unit (14) and the execution by said processing unit (14) of predetermined processing.

9. Device (10) according to the previous claim and any one of claims 2 to 5, **characterised in that** said processing unit (14) is adapted, in said wake state, to cause the emission, by said unit (22) for transmitting radiofrequency signals, either of an alert signal, in the event of detection of said floating potential, or of a tracking signal, at predetermined time intervals, in the event of detection of said predetermined potential.

10. Device (10) according to any one of the preceding claims, **characterised in that** it comprises a first and a second electrical cable (12) and a processing unit (14) comprising first and second inputs (16) respectively connected to said first and second electrical cables (12), said processing unit (14) being adapted to detect, on said first input (16), either a first predetermined potential, indicative of the integrity of said first electrical cable (12), or a floating potential, indicative of the break of said first electrical cable (12), and, on said second input (16), either a second predetermined potential, indicative of the integrity of said second electrical cable (12), or a floating potential, indicative of the break of said second electrical cable (12).

11. Method for detecting a break in at least one electrical cable (12), said method comprising the following steps:
apply (E1), by a power supply unit (18), a predetermined potential to said at least one electrical cable (12);
detect (E2), by a processing unit (14) powered by the power supply unit (18) and configured, by default, to adopt a deep sleep state, on at least one of said inputs (16) connected to said at least one electrical cable (12), either said predetermined potential, indicative of the integrity of said at least one electrical cable (12), or a floating potential, indicative of a break in said at least one electrical cable (12), said floating potential being detected by the transition of said at least one processing unit (14) to a wake state.

12. Method according to the previous claim, **characterised in that** it further comprises a step (E3) consisting of sending, by a unit (22) for transmitting radiofrequency signals, an alert signal in the event of detection of said floating potential.

13. Method according to the preceding claim, **characterised in that** said step (E3) of sending said alert signal comprises sending a message to a mobile telecommunications terminal, via a telecommunications network.
